# FASCICULE DE BREVET EUROPEEN

(11) **EP 3 373 053 B1**
(45) Date de publication et mention de la délivrance du brevet: **23.02.2022**
(21) Numéro de dépôt: 18160425.7
(22) Date de dépôt: 07.03.2018
(51) Int. Cl.: G02B 6/38, G01M 11/00, G01L 1/04, G02B 6/42, G01B 7/00, G01D 5/04, G01B 21/16

(54) **PROCÉDÉ DE RÉGLAGE DU PARALLÉLISME D'UN BLOC DE FIBRES AVEC UNE SURFACE D'UNE PUCE**
REGULIERUNGSVERFAHREN DER PARALLELITÄT EINES FASERBLOCKS MIT EINER CHIP-OBERFLÄCHE
METHOD FOR ADJUSTING THE PARALLELISM OF A BLOCK OF FIBRES WITH A SURFACE OF A DIE

(30) Priorité: 10.03.2017 FR 1751998
(43) Date de publication de la demande: 12.09.2018
(73) Titulaire: Commissariat à l'Energie Atomique et aux Energies Alternatives, 75015 Paris (FR)
(72) Inventeur: GROSSE, Philippe, 38360 SASSENAGE (FR)
(74) Mandataire: Cabinet Beaumont

(56) Documents cités:
- KR-A- 20040 019 516
- US-A1- 2002 110 335
- US-A1- 2003 113 069
- US-A1- 2004 052 470
- US-A1- 2007 175 563
- US-B1- 6 325 551
- US-B1- 6 556 751

## Description

### Domaine

La présente demande concerne un procédé de réglage du parallélisme d'un bloc de fibres avec une surface d'une puce ou tranche semiconductrice posée sur une table XY. La présente demande concerne également une station de test adaptée à la mise en œuvre d'un tel procédé.

### Exposé de l'art antérieur

Des circuits optiques intégrés sont couramment fabriqués à partir d'une tranche d'un matériau semiconducteur, ou tranche semiconductrice, qui est ensuite découpée pour obtenir une pluralité de puces individuelles. Avant l'étape de découpe, des tests sont effectués pour vérifier que les circuits optiques sont fonctionnels.

Pour tester un circuit optique intégré, des signaux optiques sont fournis à des entrées optiques du circuit, et les valeurs de signaux de sortie correspondants sont observées, ces signaux de sortie pouvant être des signaux optiques disponibles au niveau de sorties optiques du circuit. Les signaux optiques sont fournis simultanément à plusieurs entrées optiques du circuit au moyen d'un bloc de fibres optiques, c'est-à-dire un bloc parallélépipédique dans lequel sont maintenues en place plusieurs fibres optiques parallèles, coplanaires et régulièrement réparties. Les extrémités de ces fibres affleurent au niveau de la face inférieure du bloc et sont réparties comme des entrées et/ou sorties optiques du circuit. Ainsi, en positionnant correctement le bloc de fibres au-dessus de ces entrées et/ou sorties optiques, chaque fibre optique a son extrémité disposée au-dessus d'une entrée ou d'une sortie optique correspondante.

Pour que le test soit correct, les distances entre les extrémités des fibres et les entrées ou sorties optiques correspondantes doivent être identiques, par exemple à ± 2,5 µm, pour toutes les fibres du bloc. Les extrémités des fibres étant toutes à l'aplomb de la face inférieure du bloc, cette face doit être aussi parallèle que possible à la face supérieure de la puce ou de la tranche semiconductrice comprenant le circuit optique à tester. En pratique, la puce semiconductrice est disposée sur la face supérieure d'une table XY et il suffit que la face inférieure du bloc soit parallèle à la face supérieure de la table XY.

Un procédé connu pour régler le parallélisme de ces deux faces repose sur l'utilisation de plusieurs caméras disposées autour du bloc de fibres afin de visualiser l'orientation de sa face inférieure par rapport à la face supérieure de la puce semiconductrice ou de la table XY. L'orientation du bloc est alors ajustée jusqu'à rendre ces faces sensiblement parallèles. Cependant, il est difficile de trouver un compromis entre le grossissement et le champ de chaque caméra qui permette de visualiser simultanément le bloc de fibres et la face supérieure de la puce ou de la table tout en conservant une précision suffisante. Il est également difficile de trouver un compromis entre le coût des caméras et leur résolution dont dépend la précision du réglage. Ce procédé est donc peu précis et coûteux. De plus, sa mise en œuvre peut s'avérer complexe, d'autant plus que les matériaux transparents sont difficiles à observer avec précision par une caméra : il y a des problèmes de réfraction et réflexion qui limitent la résolution de la caméra et qui rendent les contours flous.

Le document US 6325551 concerne un procédé et un appareil pour aligner optiquement des fibres optiques avec des dispositifs optiques. Le documents KR 20040019516 concerne un procédé et un appareil d'alignement de l'axe optique d'une fibre optique. Le document US 2003/113069 concerne un système pour l'alignement d'une fibre optique.

### Résumé

Il serait souhaitable de disposer d'un procédé de réglage du parallélisme d'un bloc de fibres avec une table XY qui soit plus précis, moins coûteux, et plus simple à mettre en œuvre que les procédés existants.

Ainsi, un mode de réalisation prévoit un procédé de réglage du parallélisme d'une face d'un bloc de fibres optiques avec une face d'une puce ou tranche semiconductrice posée sur une table XY, comprenant les étapes suivantes :
a) prévoir un capteur solidaire de la table XY et un bras manipulateur portant le bloc, ladite face étant tournée vers la table XY ;
b) pour chacun de trois points non alignés de la face du bloc, effectuer un déplacement l'un par rapport à l'autre de la table XY et du bloc dans les directions X et/ou Y pour mettre le capteur en regard du point, et évaluer, avec le capteur, la distance en Z entre le point et le capteur ; et
c) modifier l'orientation du bloc au moyen du bras manipulateur pour assurer le parallélisme recherché.

Selon un mode de réalisation, le capteur est un capteur de contact, l'étape b) comprenant, pour chaque point, déplacer le bloc en Z à partir d'une position de référence jusqu'à une position de mise en contact avec le capteur, et déterminer la distance en Z parcourue par le bloc entre les positions de référence et de mise en contact.

Selon un mode de réalisation, le déplacement en Z du bloc est assuré par un moteur pas à pas, associé à un moyen de mesure de nombre de pas.

Selon un mode de réalisation, le capteur comprend un élément déformable en Z, un dispositif de mesure de la déformation en Z, et un élément de contact monté sur l'élément déformable, l'étape b) comprenant, pour chaque point, déplacer le bloc en Z jusqu'à déformer l'élément déformable en Z, et déterminer la distance en Z parcourue par le bloc entre la position de référence et une position de mise en contact du point et de l'élément de contact.

Selon un mode de réalisation, l'élément de contact est une bille, l'élément déformable en Z est une lamelle flexible et le dispositif de mesure de la déformation est une jauge de contrainte disposée sur la lamelle.

Selon un mode de réalisation, à l'étape b), le déplacement de la table XY et du bloc l'un par rapport à l'autre est réalisé en déplaçant la table XY.

Selon un mode de réalisation, chaque point est au voisinage d'un coin de ladite face.

Selon un mode de réalisation, après chaque évaluation de deux distances en Z faite à l'étape b), l'étape c) est en partie effectuée en modifiant l'orientation du bloc sur la base du déplacement en X et/ou en Y effectué entre ces deux points et de la différence de distance en Z correspondante.

Il serait également souhaitable de disposer d'une station de test pour mettre en œuvre ce procédé, de préférence au moins en partie de façon automatique.

Ainsi, un mode de réalisation prévoit une station de test comprenant un bras manipulateur et une table XY, adaptée à mettre en œuvre le procédé ci-dessus.

Selon un mode de réalisation, la station de test comprend en outre un circuit de commande et de traitement adapté à recevoir un signal de sortie du capteur, à mémoriser les distances en Z, et à fournir des signaux de commande à la table XY et au bras manipulateur pour mettre en œuvre le procédé de manière automatique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue schématique et en perspective d'une station de test ;
les figures 2A à 2C sont des vues schématiques d'un exemple de bloc de fibres utilisé dans la station de test de la figure 1 ; et
les figures 3A, 3B et 4A, 4B illustrent schématiquement des étapes d'un mode de réalisation d'un procédé d'alignement d'un bloc de fibres avec une table XY.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, les termes "supérieur" et "inférieur" se réfèrent à la position des éléments concernés dans les figures correspondantes. Sauf précision contraire, le terme "environ" signifie à 10 % près, de préférence à 5 % près.

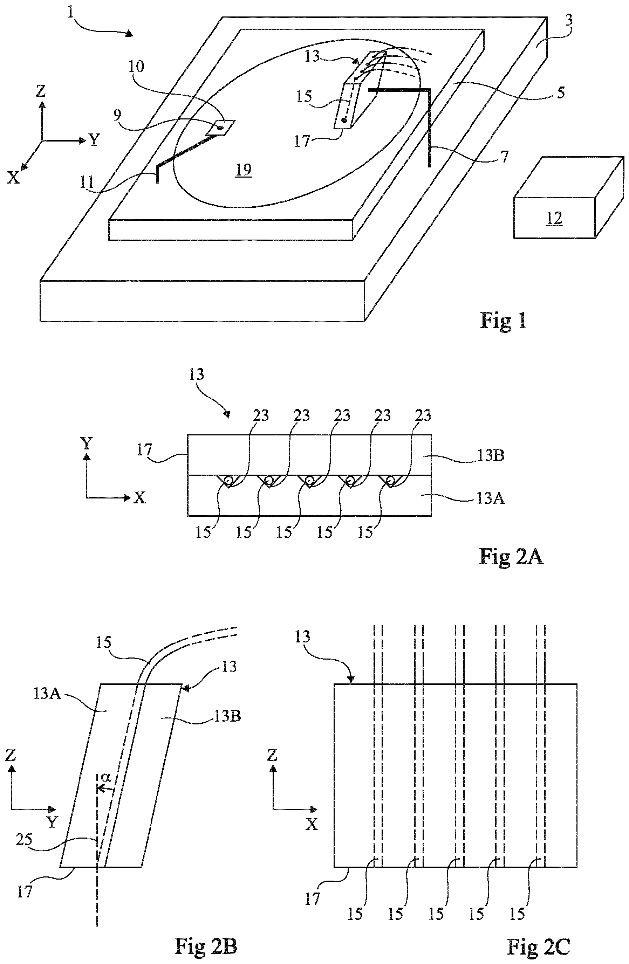

La figure 1 est une vue en perspective schématique d'une station de test adaptée à la mise en œuvre d'un procédé de réglage du parallélisme d'un bloc de fibres optiques avec une face d'une puce disposée sur une table XY.

La station de test 1 comprend, dans un repère orthonormé défini par trois directions ou axes X, Y et Z, un bâti 3 sur lequel repose une table XY 5. La face supérieure de la table XY 5 est parallèle au plan défini par les directions X et Y. La station de test 1 comprend un bras manipulateur 7 solidaire du bâti 3. La station de test 1 comprend en outre un capteur 9 solidaire de la table 5. Ainsi, lorsque la table 5 est déplacée dans les directions X et/ou Y, le capteur 9 est déplacé de la même façon, parallèlement au plan défini par ces directions X et Y. Dans cet exemple, le capteur est disposé sur un support 10 monté à l'extrémité d'un bras 11 fixé à la table 5. Un circuit de commande et de traitement 12 reçoit le signal de sortie du capteur 9 et fournit des signaux de commande au bras manipulateur 7 et à la table XY 5.

Lors d'une phase de test, un bloc 13 de fibres optiques 15 est fixé au bras manipulateur 7, couramment au niveau d'une extrémité de celui-ci. Le bloc 13 est disposé de sorte que sa face inférieure 17, au niveau de laquelle affleurent les extrémités des fibres 15, est tournée vers la face supérieure de la table XY 5. En outre, une puce semiconductrice 19 est disposée sur la table XY 5, la face supérieure de la puce 19 étant parallèle au plan défini par les directions X et Y.

Le bras manipulateur 7 est adapté à déplacer le bloc 13 au moins dans la direction Z. Le bras manipulateur 7 est également adapté à modifier l'orientation du bloc par rapport à la table XY 5, en appliquant des rotations au bloc 13 au moins autour de deux axes différents de l'axe Z. Le bras manipulateur 7 est par exemple un bras manipulateur six axes dont l'extrémité portant le bloc 13 est mobile en translation dans les directions X, Y et Z et en rotation autour des axes X, Y et Z. Les déplacements en translation et en rotation du bras manipulateur 7, et les déplacements en translation de la table XY 5 sont effectués par l'intermédiaire de dispositifs de déplacements (non représentés), par exemple des moteurs pas à pas ou des vis de réglage micrométrique. Ces dispositifs de déplacement sont commandés ou pilotés de manière automatique par les signaux de commande fournis par le circuit de traitement et de commande 12.

Les figures 2A, 2B et 2C sont des vues schématiques respectivement de dessous, de côté et de face du bloc 13 de fibres 15 de la figure 1.

Dans cet exemple, le bloc 13 est constitué de deux plaques en verre 13A et 13B collées l'une à l'autre. La plaque 13A comprend des rainures 23 au niveau de sa face collée à la plaque 13B, par exemple des rainures en forme de V. Dans chaque rainure 23 est disposée une fibre 15. Dans cet exemple, le bloc 13 comprend cinq fibres 15 étant entendu que, en pratique, le bloc 13 peut comprendre un nombre quelconque de fibres 15 supérieur ou égal à deux. Les entrées et les sorties optiques d'un circuit intégré optique à tester sont couramment constituées par des réseaux de couplage dont chacun est disposé à une extrémité d'un guide d'onde. Pour optimiser le couplage des fibres 15 avec ces réseaux de couplage, l'angle α entre la normale 25 à la face inférieure 17 du bloc 13 et l'axe de chaque fibre 15 est choisi en fonction des réseaux de couplage utilisés, et est par exemple compris entre 3 et 15°, par exemple 8°. A titre d'exemple, pour un bloc 13 muni de huit fibres 15 réparties à un pas qui, selon les normes actuelles, est couramment de 127 ou 250 µm, la face inférieure 17 du bloc a par exemple une largeur d'environ 2 mm pour une longueur d'environ 4,5 mm.

Un mode de réalisation d'un procédé de réglage du parallélisme de la face inférieure du bloc 13 de fibres 15 avec la face supérieure de la table XY 5, mis en œuvre dans la station de test 1, va maintenant être décrit.

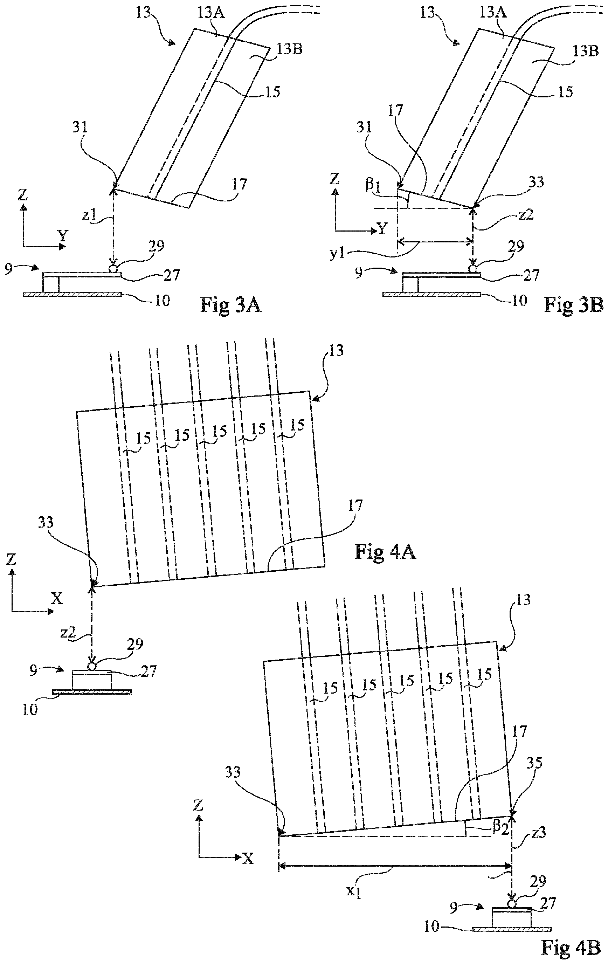

Les figures 3A, 3B, 4A et 4B illustrent des étapes successives d'un tel procédé, les figures 3A et 3B étant des vues de côté du capteur 9 reposant sur le support 10 et du bloc 13 de fibres 15 et les figures 4A et 4B étant des vues de face de ces mêmes éléments.

Dans ce mode de réalisation, le capteur 9 est un capteur de contact. Plus particulièrement, le capteur 9 comprend un élément déformable en Z, par exemple une lamelle flexible 27, et un dispositif de mesure de la déformation en Z de cet élément, par exemple une jauge de contrainte non représentée disposée sur la face supérieure ou inférieure de la lamelle 27. En variante, l'élément déformable en Z et le dispositif de mesure de la déformation en Z correspondent à une lamelle piézoélectrique. Le capteur comprend en outre une bille 29 ou une pointe reposant sur la face supérieure de la lamelle flexible 27 et permettant d'assurer un contact ponctuel du capteur 9 avec une surface. A titre d'exemple, la lamelle 27 a une longueur comprise entre 10 et 20 mm, par exemple 12 mm, et une largeur comprise entre 3 et 10 mm, par exemple 4 mm. La bille 29 est par exemple en verre, et a par exemple un diamètre compris entre 1,5 et 0,5 mm, par exemple 1 mm environ.

A l'étape de la figure 3A, la bille 29 du capteur 9 est mise en regard d'un point 31 de la face inférieure 17 du bloc 13 de fibres 15 en déplaçant la table XY 5, donc le capteur 9, dans les directions X et Y. Le bloc 13 est ensuite déplacé en Z à l'aide du bras manipulateur 7, depuis une position de référence en Z jusqu'au capteur 9. A partir de la mise en contact du point 31 et la bille 29, le déplacement en Z entraîne une déformation de la lamelle 27 qui est détectée, sur le signal de sortie du capteur 9, par le circuit de commande et de traitement 12. Ce dernier détermine alors de manière automatique la distance z1 parcourue en Z par le bloc 13 depuis sa position de référence jusqu'à sa mise en contact avec le capteur 9. Le bloc 13 est ensuite replacé dans sa position de référence comme cela est représenté en figure 3A.

A l'étape de la figure 3B, la bille 29 du capteur 9 est mise en regard d'un point 33 de la face inférieure 17 du bloc 13 de fibres 15 en déplaçant la table XY 5 d'une distance y1 dans la direction Y. La distance en Z, z2, entre la bille 29 et le point 33 du bloc 13 dans sa position de référence est déterminée par le circuit 12 de manière similaire à la distance z1. Le bloc 13 est ensuite remis dans sa position de référence.

Aux étapes des figures 4A et 4B, le capteur 9, le support 10 et le bloc 13 de fibres 15 sont représentés en vue de face.

A l'étape de la figure 4A, le bloc 15, le capteur 9 et le support 10 sont dans les mêmes positions qu'à la fin de l'étape illustrée en figure 3B.

A l'étape de la figure 4B, la bille 29 du capteur 9 est mise en regard d'un point 35 de la face inférieure 17 du bloc 13 en déplaçant la table 5 d'une distance x1 dans la direction X. La distance en Z, z3, entre la bille 29 et le point 35 du bloc 13 dans sa position de référence est déterminée par le circuit de manière similaire aux distances z1 et z2. Le bloc 13 est ensuite remis dans sa position de référence.

A une étape suivante non illustrée, les différences de distance en Z entre les points 31 et 33 et entre les points 33 et 35, par rapport au capteur 9, sont évaluées automatiquement par le circuit de commande et de traitement 12 à partir des distances mémorisées z1, z2 et z3. Connaissant ces différences de distance en Z et les distances x1 et y1, en appliquant des formules de trigonométrie, le circuit de commande et de traitement 12 détermine automatiquement l'orientation de la face 17 du bloc 13 par rapport à la surface supérieure de la table XY 5 ou de la puce semiconductrice 19. En pratique, le circuit de commande et de traitement 12 calcule l'angle β1 entre la face 17 du bloc 13 et la table XY 5 dans un plan orthogonal à la table XY 5 comprenant les points 31 et 33 (figure 3B), et l'angle β2 entre la face 17 du bloc 13 et la table XY 5 dans un plan orthogonal à la table XY 5 comprenant les points 33 et 35 (figure 4B).

A une étape suivante non illustrée, à partir des angles β1 et β2, le circuit de commande et de traitement 12 détermine de manière automatique les signaux de commande à fournir aux dispositifs de déplacement en rotation du bras 7 pour modifier l'orientation du bloc 13 par rapport à la table XY et assurer le parallélisme recherché. Dans l'exemple décrit en relation avec les figures 3A, 3B, 4A et 4B, cela correspond à appliquer au bloc une rotation d'angle β1 autour de l'axe X et une rotation d'angle β2 autour de l'axe Y.

De préférence, dans le procédé décrit ci-dessus, les points 31, 33 et 35 de la face inférieure 17 du bloc 13 sont choisis proches de coins de cette face 17. Il en résulte que les distances de déplacement dans les directions X et Y sont importantes ce qui limite l'influence d'une éventuelle erreur absolue de déplacement dans ces directions, et permet une meilleure précision de réglage du parallélisme.

Selon un avantage, les capteurs de contact sont des dispositifs simples et peu coûteux et leur utilisation est particulièrement simple et efficace. En effet, comme cela a été indiqué précédemment, ils peuvent être utilisés pour mesurer la distance entre une position de référence du bras manipulateur et une position de contact sans qu'il soit nécessaire de faire une mesure absolue de distance. De préférence, les déplacements en Z du bras manipulateur sont assurés par un moteur pas à pas et il suffira, connaissant la valeur d'un pas, de compter le nombre de pas entre les deux positions du bras manipulateur.

Selon un autre avantage, malgré leur simplicité et leur faible coût, les capteurs de contact permettent d'obtenir des précisions de mesure en Z conduisant à un réglage du parallélisme avec la précision requise. En particulier, dans le cas du capteur de contact 9 décrit précédemment, il suffit de repérer quand la lamelle 27 commence à être déformée mais il n'est pas utile de connaître avec précision l'amplitude de cette déformation. A titre d'exemple, si on utilise un capteur constitué d'une lame de 4 mm x 12 mm et une jauge de contrainte de 120 ohms (2,5 mm x 6 mm) on obtient une précision de mesure de 5 µm, c'est-à-dire que le capteur 9 permet de déterminer l'angle β1 avec une précision de 0,06° et l'angle β2 avec une précision de 0,015° quand la face 17 a les dimensions indiquées en relation avec les figures 2A à 2C.

Selon encore un autre avantage, par rapport à la plupart des capteurs de distance, les capteurs de contact ne sont pas sensibles à la nature du ou des matériaux de la surface par rapport à laquelle on mesure la distance.

Selon encore un autre avantage, le capteur 9 décrit ici ne nécessite aucune phase d'étalonnage.

Selon encore un autre avantage, un capteur de contact peut être positionné grossièrement sans que cela n'affecte la mesure de distance en axe Z contrairement à d'autres capteurs tels que des capteurs optiques qui nécessitent d'être parfaitement alignés sur l'axe Z.

Selon encore un autre avantage, la consommation électrique d'un capteur de contact, en particulier du capteur 9 décrit ci-dessus, est très faible.

Le procédé décrit ci-dessus en relation avec les figures 3A, 3B, 4A et 4B est susceptible de nombreuses variantes de réalisation.

Dans une première variante, le capteur de contact 9 est remplacé par un autre capteur de distance en Z, par exemple un capteur de distance optique tel qu'un capteur temps de vol, un capteur de distance capacitif, un capteur de distance inductif, un capteur de distance magnéto-inductif, ou un capteur à courant de Foucault. Dans ce cas, le déplacement du bloc 13 en Z pour mesurer chacune des distances z1, z2 et z3 peut ne pas être nécessaire. On préfère toutefois utiliser un capteur de contact qui présente les avantages exposés ci-dessus, les autres capteurs étant de façon générale moins simples, plus coûteux et plus difficiles à utiliser. Par exemple, un capteur de distance optique du type temps de vol nécessite une source d'émission de lumière et un récepteur de lumière, et coûte donc bien plus cher qu'un capteur de contact. En outre la source d'émission de lumière et le capteur doivent être synchronisés ce qui rend ces capteurs temps de vol complexes.

Dans une deuxième variante de réalisation, l'orientation du bloc 13 par rapport à la table XY 5 est modifiée après chaque évaluation d'une différence de distance en Z entre deux points par rapport au capteur 9. Par exemple, après les étapes des figures 3A et 3B, l'angle β1 est calculé sur la base de la distance y1 et de la différence de distance en Z, z1-z2, entre les points 31 et 33, et une rotation d'angle β1 autour de l'axe X est appliquée au bloc 13 pour ajuster le parallélisme. Ensuite seulement, les étapes des figures 4A et 4B sont effectuées, une nouvelle mesure de la distance z2 étant effectuée à l'étape de la figure 4A. L'angle β2 est alors calculé sur la base de la distance x1 et de la différence de distance en Z, z2-z3, entre les points 33 et 35, et une rotation d'angle β2 autour de l'axe Y est appliquée au bloc 13 pour corriger le parallélisme.

Dans une troisième variante de réalisation, les relations entre les commandes appliquées aux dispositifs de déplacement en rotation du bras 7 et les angles des rotations en résultant ne sont pas connues. Dans ce cas, le procédé décrit ci-dessus peut être mis en œuvre par approximations successives. L'orientation de bloc 13 est modifiée grossièrement sur la base des angles β1 et β2. Les étapes des figures 3A à 4B et de modification grossière de l'orientation du bloc 13 sont ensuite répétées jusqu'à obtenir des différences de distance en Z et des angles β1 et β2 qui soient nuls ou presque.

Dans une quatrième variante de réalisation, le bloc 13 peut être déplacé en X et en Y par rapport à la table XY 5 et au capteur 9 plutôt que l'inverse comme cela a été décrit en relation avec les figures 3A, 3B, 4A et 4B. Toutefois, lorsqu'il n'est pas certain que le bloc 13 est déplacé de manière parallèle à la surface supérieure de la table XY 5, on préfère déplacer en X et en Y l'ensemble du capteur 9 et de la table XY 5 par rapport au bloc 13. Cela assure que la face inférieure 17 du bloc 13 est rendue parallèle à la surface supérieure de la table XY 5.

Un mode de réalisation particulier et des variantes de réalisation particulières ont été décrites. D'autres variantes et modifications apparaîtront à l'homme de l'art. En particulier, l'homme de l'art est en mesure d'appliquer les enseignements de la présente demande au cas où, entre deux mesures de distance en Z, le déplacement de la table XY et du bloc de fibres l'un par rapport à l'autre correspond à une composition d'un déplacement selon la direction X et d'un déplacement selon la direction Y. De plus, les directions de déplacement entre plusieurs mesures de distance en Z peuvent ne pas être orthogonales.

La répartition des fibres 15 dans le bloc 13 peut être différente de celle décrite ci-dessus. Les fibres 15 peuvent ne pas être coplanaires et/ou ne pas être réparties selon un pas donné.

Le capteur 9 peut être disposé à tout emplacement choisi dès lors qu'il est solidaire du mouvement de la table XY. Par exemple, le capteur 9 peut être disposé sur la table XY 5 ou sur la puce semiconductrice 19.

Bien entendu, au moins certaines des étapes décrites précédemment peuvent être mises en œuvre de manière non automatique.

En outre, bien que trois points de mesure suffisent pour mettre en œuvre le procédé ci-dessus, plus de trois points de mesure peuvent être prévus, par exemple quatre points de mesure pouvant chacun correspondre à un coin de la face 17.

Le procédé ci-dessus peut en outre être mis en œuvre dans d'autres applications. En effet, le bloc de fibres peut être remplacé par tout autre élément comprenant une face que l'on cherche à rendre parallèle à la face supérieure de la table XY ou d'un dispositif reposant sur cette table. Par exemple, le procédé ci-dessus peut être mis en œuvre pour rendre parallèle une face d'un prisme optique avec la surface supérieure d'une puce reposant sur la table XY et comprenant une source d'émission de lumière que l'on souhaite étudier. Selon un autre exemple, le procédé ci-dessus peut être mis en œuvre dans une station de conditionnement comprenant une table XY et un bras manipulateur pour réaliser, lors de la mise en boîtier d'une puce de circuits optiques intégrés, l'alignement d'un bloc de fibres avec des entrées/sorties optiques de cette puce.

Divers modes de réalisation avec diverses variantes ont été décrits ci-dessus. On notera que l'homme de l'art pourra combiner divers éléments de ces divers modes de réalisation et variantes sans faire preuve d'activité inventive. En particulier, les quatre variantes de réalisation décrites précédemment peuvent toutes être combinées entre elles.

En outre, on notera qu'après avoir effectué les étapes du procédé décrit ci-dessus, diverses étapes peuvent être réalisées, notamment des étapes de test. Des modifications peuvent alors être apportées à la station de test 1 décrite en relation avec la figure 1 pour mettre en œuvre ces étapes. Par exemple, lors d'une phase de test, pour s'assurer que la distance en Z entre la puce semiconductrice 19 et la face inférieure du bloc 13 reste constante, un capteur de distance en Z tourné vers la puce semiconductrice 19 peut être fixé à l'extrémité du bras 7 portant le bloc 13. Ainsi, la distance en Z entre la puce semiconductrice 19 et la face inférieure 17 du bloc 13 est mesurée après chaque déplacement, et le cas échéant, corrigée en déplaçant le bloc 13 en Z.

## Revendications

1. Procédé de réglage du parallélisme d'une face (17) d'un bloc (13) de fibres optiques (15) avec une face d'une puce ou tranche semiconductrice posée sur une table XY (5), comprenant les étapes suivantes :
a) prévoir un capteur (9) solidaire de la table XY et un bras manipulateur (7) portant le bloc, ladite face (17) étant tournée vers la table XY ;
b) pour chacun parmi un ensemble de points (31, 33, 35) de la face (17) du bloc (13), dont trois au moins sont non alignés, effectuer un déplacement (x1, y1) l'un par rapport à l'autre de la table XY (5) et du bloc (13) dans les directions X et/ou Y pour mettre le capteur (9) en regard du point (31, 33, 35), et évaluer, avec le capteur (9), la distance en Z entre le point (31, 33, 35) et le capteur ; et
c) modifier, en tenant compte des distances en Z, l'orientation du bloc (13) au moyen du bras manipulateur (7) pour assurer le parallélisme recherché.

2. Procédé selon la revendication 1, dans lequel le capteur (9) est un capteur de contact, l'étape b) comprenant, pour chaque point (31, 33, 35), déplacer le bloc (13) en Z à partir d'une position de référence jusqu'à une position de mise en contact avec le capteur (9), et déterminer la distance en Z (z1, z2, z3) parcourue par le bloc entre les positions de référence et de mise en contact.

3. Procédé selon la revendication 2, dans lequel le déplacement en Z du bloc (13) est assuré par un moteur pas à pas, associé à un moyen de mesure de nombre de pas.

4. Procédé selon la revendication 2 ou 3, dans lequel le capteur (9) comprend un élément déformable en Z (27), un dispositif de mesure de la déformation en Z, et un élément de contact (29) monté sur l'élément déformable (27), l'étape b) comprenant, pour chaque point (31, 33, 35), déplacer le bloc (13) en Z jusqu'à déformer l'élément déformable en Z (27), et déterminer la distance en Z (z1, z2, z3) parcourue par le bloc (13) entre la position de référence et une position de mise en contact du point (31, 33, 35) et de l'élément de contact (29).

5. Procédé selon la revendication 4, dans lequel l'élément de contact est une bille (29), l'élément déformable en Z est une lamelle flexible (27) et le dispositif de mesure de la déformation est une jauge de contrainte disposée sur la lamelle (27) .

6. Procédé selon l'une quelconque des revendications 1 à 5, dans lequel, à l'étape b), le déplacement (x1, y1) de la table XY (5) et du bloc (13) l'un par rapport à l'autre est réalisé en déplaçant la table XY (5).

7. Procédé selon l'une quelconque des revendications 1 à 6, dans lequel chaque point (31, 33, 35) est disposé au voisinage d'un coin de ladite face (17).

8. Procédé selon l'une quelconque des revendications 1 à 7, dans lequel après chaque évaluation de deux distances en Z faite à l'étape b), l'étape c) comprend une modification de l'orientation du bloc sur la base du déplacement en X et/ou en Y effectué entre ces deux points et de la différence de distance en Z correspondante.

9. Station de test (1) comprenant :
un table XY (5) sur laquelle une puce ou tranche semiconductrice est destinée à être posée ;
un capteur (9) solidaire de la table XY ; et
un bras manipulateur (7) adapté à porter un bloc (13) de fibres optiques (15) de sorte qu'une face (17) du bloc (13) est tournée vers la table XY (5), le bras (7) et la table (5) étant configurés pour, pour chacun parmi un ensemble de points (31, 33, 35) de la face (17) du bloc (13), dont trois au moins sont non alignés, effectuer un déplacement (x1, y1) l'un par rapport à l'autre de la table XY (5) et du bloc (13) dans les directions X et/ou Y pour mettre le capteur (9) en regard du point (31, 33, 35), le capteur servant à évaluer la distance en Z entre le point (31, 33, 35) et le capteur, et le bras étant configuré pour modifier l'orientation du bloc (13) pour assurer le parallélisme recherché de la face (17) du bloc (13) avec une face de la puce ou tranche semiconductrice, en tenant compte des distances en Z.

10. Station de test selon la revendication 9, comprenant en outre un circuit de commande et de traitement (12) adapté à recevoir un signal de sortie du capteur (9), à mémoriser les distances en Z, et à fournir des signaux de commande à la table XY (5) et au bras manipulateur (7) pour mettre en œuvre le procédé selon l'une quelconque des revendications 1 à 8 de manière automatique.

## Patentansprüche

1. Ein Verfahren zum Einstellen der Parallelität einer Fläche (17) eines Blocks (13) aus optischen Fasern (15) mit einer Fläche eines Halbleiterchips oder - wafers, der auf einen XY-Tisch (5) gelegt ist, wobei das Verfahren die folgenden Schritte aufweist:
a) Bereitstellen eines Sensors (9), der starr an dem XY-Tisch befestigt ist, und eines Handhabungsarms (7), der den Block trägt, wobei die Fläche (17) dem XY-Tisch gegenüberliegt;
b) für jeden aus einem Satz von Punkten (31, 33, 35) der Fläche (17) des Blocks (13), von denen mindestens drei nicht ausgerichtet sind, Verschieben (x1, y1) des XY-Tisches (5) und des Blocks (13) in Bezug aufeinander in den Richtungen X und/oder Y, um den Sensor (9) gegenüber dem Punkt (31, 33, 35) anzuordnen, und Schätzen des Abstands entlang der Richtung Z zwischen dem Punkt (31, 33, 35) und dem Sensor mit dem Sensor (9); und
c) Ändern der Ausrichtung des Blocks (13) mittels des Handhabungsarms (7) unter Berücksichtigung der Abstände entlang der Z-Richtung, um die gewünschte Parallelität herzustellen.

2. Verfahren nach Anspruch 1, wobei der Sensor (9) ein Kontaktsensor ist, wobei Schritt b) für jeden Punkt (31, 33, 35) Verschieben des Blocks (13) entlang der Z-Richtung aus einer Referenzposition in eine Position, in der er in Kontakt mit dem Sensor (9) gebracht wird, und Bestimmen der von dem Block zwischen der Referenz- und der Kontaktposition zurückgelegten Strecke entlang der Z-Richtung (z1, z2, z3) aufweist.

3. Verfahren nach Anspruch 2, wobei die Verschiebung des Blocks (13) entlang der Z-Richtung durch einen Schrittmotor gewährleistet wird, der mit Mitteln zur Messung der Anzahl der Schritte verbunden ist.

4. Verfahren nach Anspruch 2 oder 3, wobei der Sensor (9) ein entlang der Z-Richtung verformbares Element (27), eine Vorrichtung zur Messung der Verformung entlang der Z-Richtung und ein Kontaktelement (29) aufweist, das auf dem verformbaren Element (27) montiert ist, wobei Schritt b) für jeden Punkt (31, 33, 35) das Verschieben des Blocks (13) entlang der Z-Richtung aufweist, bis das entlang der Z-Richtung verformbare Element (27) verformt ist, und das Bestimmen der Strecke entlang der Z-Richtung (z1, z2, z3), die der Block (13) zwischen der Bezugsposition und einer Position zurücklegt, in der der Punkt (31, 33, 35) in Kontakt mit dem Kontaktelement (29) gebracht wird.

5. Verfahren nach Anspruch 4, wobei das Kontaktelement eine Kugel (29) ist, das entlang der Z-Richtung verformbare Element eine flexible Klinge (27) ist und die Verformungsmessvorrichtung ein auf der Klinge (27) angeordneter Dehnungsmessstreifen ist.

6. Verfahren nach einem der Ansprüche 1 bis 5, wobei in Schritt b) die Verschiebung (x1, y1) des XY-Tisches (5) und des Blocks (13) in Bezug aufeinander durch Verschieben des XY-Tisches (5) erfolgt.

7. Verfahren nach einem der Ansprüche 1 bis 6, wobei jeder Punkt (31, 33, 35) in der Nähe einer Ecke der Fläche (17) angeordnet ist.

8. Verfahren nach einem der Ansprüche 1 bis 7, wobei nach jeder in Schritt b) durchgeführten Schätzung von zwei Abständen entlang der Z-Richtung Schritt c) eine Änderung der Ausrichtung des Blocks auf der Grundlage der zwischen diesen beiden Punkten durchgeführten Verschiebung in der X- und/oder Y-Richtung und der entsprechenden Differenz zwischen den Abständen entlang der Z-Richtung aufweist.

9. Eine Prüfstation (1), die Folgendes aufweist:
einen XY-Tisch (5), auf den ein Halbleiterchip oder -wafer gelegt werden soll;
einen Sensor (9), der starr an dem XY-Tisch befestigt ist; und
einen Handhabungsarm (7), der in der Lage ist, einen Block (13) optischer Fasern (15) so zu tragen, dass eine Fläche (17) des Blocks (13) dem XY-Tisch (5) zugewandt ist, wobei der Arm (7) und der Tisch (5) so konfiguriert sind, dass sie für jeden aus einer Gruppe von Punkten (31, 33, 35) der Fläche (17) des Blocks (13), von denen mindestens drei nicht ausgerichtet sind, eine Verschiebung des XY-Tisches (5) und des Blocks (13) in Bezug zueinander in X- und/oder Y-Richtung durchzuführen, um den Sensor gegenüber dem Punkt (31, 33, 35) gegenüberzustellen, wobei der Sensor zum Auswerten des Abstands entlang der Z-Achse zwischen dem Punkt (31, 33, 35) und dem Sensor verwendet wird und der Arm so konfiguriert ist, dass er die Ausrichtung des Blocks (13) modifiziert, um die gewünschte Parallelität der Fläche (17) des Blocks (13) mit einer Fläche des Halbleiterchips oder -wafers bereitzustellen, indem er die Abstände entlang der Z-Richtung berücksichtigt.

10. Prüfstation nach Anspruch 9, die ferner eine Steuer- und Verarbeitungsschaltung (12) aufweist, die in der Lage ist, das Ausgangssignal des Sensors (9) zu empfangen, die Abstände entlang der Z-Richtung zu speichern und Steuersignale an den XY-Tisch (5) und an den Handhabungsarm (7) zu liefern, um das Verfahren nach einem der Ansprüche 1 bis 8 automatisch durchzuführen.

## Claims

1. A method of adjusting the parallelism of a face (17) of a block (13) of optical fibers (15) with a face of a semiconductor chip or wafer laid on an XY table (5), comprising the steps of:
a) providing a sensor (9) rigidly attached to the XY table and a handling arm (7) supporting the block, said face (17) facing the XY table;
b) for each among a set of points (31, 33, 35) of the face (17) of the block (13), at least three of which are non-aligned, displacing (x1, y1) with respect to each other the XY table (5) and the block (13) in directions X and/or Y to place the sensor (9) opposite the point (31, 33, 35), and estimate, with the sensor (9), the distance along the Z direction between the point (31, 33, 35) and the sensor; and
c) modifying, by taking into account the distances along the Z direction, the orientation of the block (13) by means of the handling arm (7) to provide the desired parallelism.

2. The method of claim 1, wherein the sensor (9) is a contact sensor, step b) comprising, for each point (31, 33, 35), displacing the block (13) along the Z direction from a reference position to a position where it is placed into contact with the sensor (9), and determining the distance along the Z direction (z1, z2, z3) traveled by the block between the reference and contacting positions.

3. The method of claim 2, wherein the displacement of the block (13) along the Z direction is ensured by a stepping motor, associated with means for measuring the number of steps.

4. The method of claim 2 or 3, wherein the sensor (9) comprises an element deformable along the Z direction (27), a device for measuring the deformation along the Z direction, and a contacting element (29) assembled on the deformable element (27), step b) comprising, for each point (31, 33, 35), displacing the block (13) along the Z direction until the element deformable along the Z direction (27) is deformed, and determining the distance along the Z direction (z1, z2, z3) traveled by the block (13) between the reference position and a position where the point (31, 33, 35) is placed into contact with the contacting element (29) .

5. The method of claim 4, wherein the contacting element is a ball (29), the element deformable along the Z direction is a flexible blade (27), and the deformation measurement device is a strain gauge arranged on the blade (27).

6. The method of any of claims 1 to 5, wherein, at step b), the displacement (x1, y1) of the XY table (5) and of the block (13) with respect to each other is performed by displacing the XY table (5).

7. The method of any of claims 1 to 6, wherein each point (31, 33, 35) is arranged in the vicinity of a corner of said face (17).

8. The method of any of claims 1 to 7, wherein after each estimation of two distances along the Z direction performed at step b), step c) comprises a modification of the orientation of the block based on the displacement in the X and/or Y direction performed between these two points and on the corresponding difference between distances along the Z direction.

9. A test station (1) comprising:
an XY table (5) on which a semiconductor chip or wafer is intended to be laid;
a sensor (9) rigidly attached to the XY table; and
a handling arm (7) capable of supporting a block (13) of optical fibers (15) so that a face (17) of the block (13) is facing the XY table (5), the arm (7) and the table (5) being configured to, for each among a set of points (31, 33, 35) of the face (17) of the block (13), at least three of which are non-aligned, performed a displacement of the XY table (5) and of the block (13) with respect to each other in the X and/or Y directions to put the sensor opposite to the point (31, 33, 35), the sensor being used for evaluating the distance along the Z axis between the point (31, 33, 35) and the sensor, and the arm being configured to modify the orientation of the block (13) to provide the desired parallelism of the face (17) of the block (13) with a face of the semiconductor chip or wafer, by taking into account the distances along the Z direction.

10. The test station of claim 9, further comprising a control and processing circuit (12) capable of receiving the output signal of the sensor (9), of storing the distances along the Z direction, and of supplying control signals to the XY table (5) and to the handling arm (7) to automatically implement the method according to any one of claims 1 to 8 in an automatic manner.
